# EUROPEAN PATENT APPLICATION

(11) **EP 1 498 740 A1**
(43) Date of publication of application: **19.01.2005**
(21) Application number: 04468012.2
(22) Date of filing: 15.07.2004
(51) Int. Cl.: G01R 21/133, G01R 11/24

(54) **Watthour-meter measuring circuit including a detection of an incorrect line connection**

(30) Priority: 15.07.2003 SI 200300179
(71) Applicant: Iskraemeco, Merjenje in Upravljanje Energije, D.D., 4000 Kranj (SI)
(72) Inventor: Rozman, Miro, 4248 Lesce (SI); Strle, Vojko, 1113 Ljubljana (SI); Kosmac, Milan, 4274 Zirovnica (SI); Thaler, Matjaz, 4000 Kranj (SI)
(74) Representative: Gros, Mladen

(57) **Abstract**

Analog signals from a mains-voltage sensor (1), a phase-conductor current sensor (2), and a neutral-conductor current sensor (3) are conducted each to a separate input of a basic multiplexer (4), an output signal of which is conducted to an input of an analog-to-digital converter (5). A demultiplexed digital signal from the output of the analog-to-digital converter (5) is conducted to an input of a digital signal processing circuit (6) provided for the calculation of the power delivereed to a load. Both current sensors (2, 3) are advantageously made as Rogowski coils.

The use of Rogowski coils or of one inductive current sensor together with a shunt in connection with a digital signal processing instead of expensive measuring current transformers is advantageous. The disclosed multiplexing brings the costs of the measuring system embodiment with two simultaneous current measurements closer to the costs for a usual measuring system with a single current measurement.

## Description

The invention concerns a watthour-meter measuring circuit including a detection of an incorrect line connection, which measuring circuit comprises a mains-voltage sensor, a phase-conductor current sensor, a neutral-conductor current sensor, an analog-to-digital converter and a digital signal processing circuit provided for a calculation of a power delivered to a load.

There has to be detected an electric energy theft, proceeding in such a way that voltage and current terminals of a watthour-meter measuring circuit are intentionally connected in an incorrect way or a load terminal, to which a neutral conductor terminal is to be connected, is intentionally earthed.

In order to prevent illegal operations on the watthour meter, a detector of an incorrect line connection is mounted therein. It must be made economically so that it does not raise the watthour-meter price for more than ten percent.

A watthour-meter measuring circuit including a detection of an incorrect line connection is described in an application note AN-563 by Analog Devices, USA. A phase-conductor current sensor and a neutral-conductor current sensor are connected - this is necessary in the case of two different current sensors - each to its own analog-to-digital converter. Both digital current signals are conducted to a circuit, which conducts the larger one to a first input of a multiplier or a digital signal processing circuit provided for calculating the power delivered to a load. A signal from a mains-voltage sensor is conducted to a second input of the multiplier. Thus a correct registration of the electric energy consumption is accomplished also when the attachment terminals are interchanged or a neutral conductor terminal on the load is earthed. Measuring current transformers or a measuring current transformer together with a shunt are used as the current sensors. It has turned out that an interfering influence of an external magnetic field, which can bring the measuring current transformer into a state of saturation, cannot be eliminated in an economical manner. A magnetic shield namely raises the circuit price. The use of two analog-to-digital converters requires a larger integrated circuit having a higher current consumption and a higher price.

Consequently, the technical problem to be solved by the present invention is to propose an inexpensive watthour-meter measuring circuit including a detection of an incorrect line connection.

According to the invention the said technical problem is solved by a watthour- meter measuring circuit of said kind, features of which according to the invention are comprised in the characterizing parts of the first and the eighth claim. Features of further embodiments of the invention are specified in dependent claims.

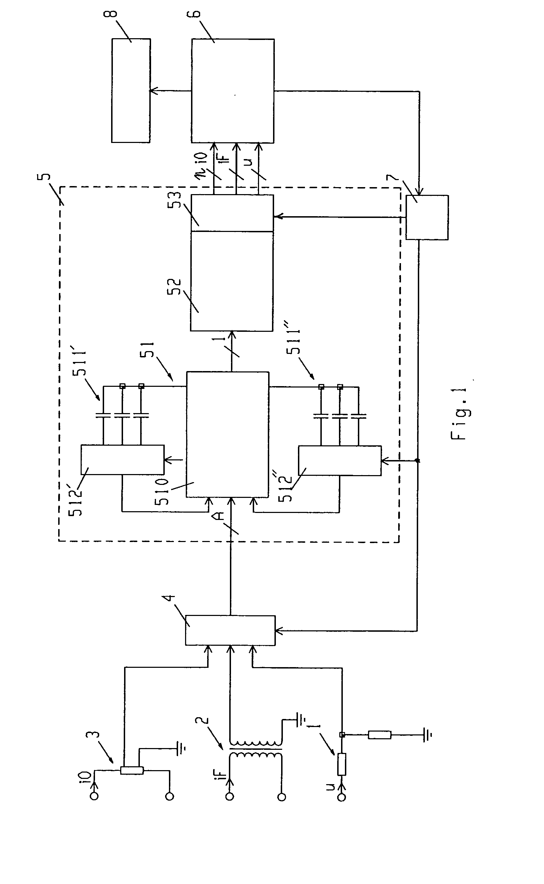

The invention will now be explained in more detail by way of the description of a first embodiment in several variants and of a second embodiment with reference to the accompanying drawing representing, in the sole Figure, the first embodiment of the watthour-meter measuring circuit including a detection of an incorrect line connection.

In a first embodiment a watthour-meter measuring circuit including a detection of an incorrect line connection consists of a sensor 1 of a mains-voltage u, a current sensor 2 of a phase-conductor current iF and a current sensor 3 of a neutral-conductor current i0 (Fig.). Three analog signals from the output of said sensors 1, 2, 3 are conducted to inputs of a basic multiplexer 4.

An analog multiplexed signal from the output of the basic multiplexer 4 is conducted to an input of the analog-to-digital converter 5 and a demultiplexed digital signal from its output is conducted to an input of a digital signal processing circuit 6, which is provided for calculating power delivered to the load. The signal processing circuit 6 is preferably a microcontroller.

At least one of the current sensors 2, 3 is preferably made as an inductive sensor outputting a time derivative of the current, e.g. a Rogowski coil, still more preferably both current sensors 2, 3 are sensors of this kind. From the current sensor the signal representing the time derivative of the current iF and/or i0 as measured each time, is conducted to the multiplexer 4.

The use of Rogowski coils or of an inductive current sensor together with a shunt in connection with digital signal processing as disclosed in patent application SI 2002 0 0166 (EP 1 378 756 A2) instead of expensive measuring current transformers is advantageous. The disclosed multiplexing brings the costs of the measuring system embodiment with two simultaneous current measurements closer to the costs for a usual measuring system with a single current measurement.

The analog-to-digital converter 5 is made of a Σ-Δ modulator 51, an output signal of which is in the 1-bit data stream form, of a decimator 52 and a demultiplexer 53 outputting three signals in the n-bit data stream form.

Said Σ-Δ modulator 51 is adapted to the multiplexed input signal in such a way that it comprises a single-channel Σ-Δ modulator 510 provided with two supplementary multiplexers 512' and 512" with three inputs each, all inputs provided with a capacitor 511' and 511 ", respectively, maintaining the content of each individual channel.

The basic multiplexer 4 and the supplementary multiplexers 512' and 512" are controlled by the first output signal of a switching matrix 7, which is controlled by the digital signal processing circuit 6, and the demultiplexer 53 is controlled by the second output signal of the switching matrix 7.

In a second embodiment a watthour-meter measuring circuit of the invention including a detection of an incorrect line connection is provided with a sensor like the first embodiment both current sensors are Rogowski coils. The output signals of both current sensors are compared to each other and the one having a larger amplitude is conducted to an input of an analog-to-digital converter and further to a digital signal processing circuit.

When the electric power values as calculated by means of the current across the phase conductor or across the neutral conductor differ from each other, the watthour meter takes the higher value for the charging. However, when this difference exceeds a preset threshold, an indicator of an incorrect line connection is turned on.

## Claims

1. Watthour-meter measuring circuit including a detection of an incorrect line connection and comprising a mains-voltage sensor (1), a phase-conductor current sensor (2), a neutral-conductor current sensor (3), an analog-to-digital converter (5) and a digital signal processing circuit (6) provided for a calculation of a power delivered to a load,
**characterized in**
**that** analog signals from the mains-voltage sensor (1), the phase-conductor current sensor (2), and the neutral-conductor current sensor (3) are conducted to inputs of a basic multiplexer (4),
**that** an analog signal from the output of the basic multiplexer (4) is conducted to an input of the analog-to-digital converter (5)
and **that** a demultiplexed digital signal from the output of the analog-to-digital converter (5) is conducted to an input of a digital signal processing circuit (6).

2. Watthour-meter measuring circuit as recited in claim 1, **characterized in**
**that** one of the current sensors (2, 3) is made as an inductive sensor.

3. Watthour-meter measuring circuit as recited in claim 1, **characterized in**
**that** both current sensors (2, 3) are made as inductive sensors.

4. Watthour-meter measuring circuit as recited in claim 2 or 3, **characterized in**
**that** a Rogowski coil is provided as the inductive sensor.

5. Watthour-meter measuring circuit as recited in any of claims 1 to 4,
**characterized in**
**that** the analog-to-digital converter (5) comprises a Σ-Δ modulator (51) adapted to a multiplexed input signal, a decimator (52) and a demultiplexer (53).

6. Watthour-meter measuring circuit as recited in claim 5, **characterized in**
**that** the Σ-Δ modulator (51) adapted to a multiplexed input signal is realised by a single channel Σ-Δ modulator (510) provided with two supplementary multiplexers (512') and (512") with three inputs each one, all being provided with a capacitor (511') and (511"), respectively.

7. Watthour-meter measuring circuit as recited in any of the previous claims,
**characterized in**
**that** the basic multiplexer (4) and supplementary multiplexers (512', 512") are controlled by a first output signal of a switching matrix (7) being controlled by the digital signal processing circuit (6), and the demultiplexer (53) is controlled by a second output signal of switching matrix (7)

8. Watthour-meter measuring circuit including a detection of an incorrect line connection and comprising a mains-voltage sensor, a phase-conductor current sensor, a neutral-conductor current sensor, an analog-to-digital converter and a digital signal processing circuit, provided for a calculation of a power delivered to a load,
**characterized in**
**that** both current sensors are made as Rogowski coils,
**that** the one of both output signals of current sensors with a larger amplitude is conducted to an input of the analog-to-digital converter and further to a digital signal processing circuit provided for the calculation of the power delivered to the load.

9. Watthour-meter measuring circuit as recited in claim 7 or 8, **characterized in**
**that** the digital signal processing circuit is a microcontroller.
